# EUROPÄISCHE PATENTSCHRIFT

(11) **EP 0 701 746 B1**
(45) Veröffentlichungstag und Bekanntmachung des Hinweises auf die Patenterteilung: **12.03.1997**
(21) Anmeldenummer: 94918781.9
(22) Anmeldetag: 25.05.1994
(51) Int. Cl.: H03D 5/00, H03D 3/24

(54) **FERNSEHTUNER FÜR TERRESTRISCHEN EMPFANG UND SATELLITENEMPFANG**
TERRESTRIAL AND SATELLITE TELEVISION RECEPTION TUNER
SYNTONISEUR TELEVISUEL POUR RECEPTION TERRESTRE ET PAR SATELLITE

(30) Priorität: 03.06.1993 DE 4318276; 17.08.1993 DE 4327631
(43) Veröffentlichungstag der Anmeldung: 20.03.1996
(73) Patentinhaber: DEUTSCHE THOMSON-BRANDT GMBH, 78048 Villingen-Schwenningen (DE)
(72) Erfinder: ARMBRUSTER, Veit, D-78112 St. Georgen (DE)
(86) Internationale Anmeldenummer: EP9401676
(87) Internationale Veröffentlichungsnummer: WO9429949

(56) Entgegenhaltungen:
- EP-A- 0 276 144
- EP-A- 0 401 932
- PATENT ABSTRACTS OF JAPAN vol. 10, no. 359 (E-460) 3. Dezember 1986 & JP,A,61 156 906 (MATSUSHITA ELECTRIC IND CO LTD) 16. Juli 1986
- PATENT ABSTRACTS OF JAPAN vol. 15, no. 36 (E-1027) 29. Januar 1991 & JP,A,02 274 022 (MATSUSHITA ELECTRIC IND CO LTD) 8. November 1990

## Beschreibung

Die Erfindung geht aus von einem Fernsehtuner gemäß dem Oberbegriff des Anspruchs 1. In einem derartigen Tuner erfolgen bei terrestrischem Empfang im allgemeinen in einer ersten Mischstufe eine Umsetzung auf eine 1.ZF und in einer darauffolgenden zweiten Mischstufe eine weitere Umsetzung auf eine 2.ZF, die dann dem ZF-Verstärker zugeführt wird. Bei Satellitenempfang erfolgt ebenfalls in einer ersten Mischstufe eine Umsetzung auf eine ZF. Diese ZF wird dann einem FM-PLL-Demodulator zugeführt, der an seinem Ausgang das Basisbandsignal des SatellitenAntennensignals liefert. Für die beiden unterschiedlichen Funktionen, nämlich terrestrischen Empfang und Satellitenempfang, sind im allgemeinen zwei getrennte Tuner vorgesehen.

Der Erfindung liegt die Aufgabe zugrunde, einen gemeinsamen Tuner für terrestrischen Empfang und Satellitenempfang zu schaffen, der insgesamt nur einen geringen Schaltungsaufwand benötigt, und bei dem möglichst viele Bauteile bei beiden Betriebsarten verwendet werden. Diese Aufgabe wird durch die im Anspruch 1 angegebene Erfindung gelöst. Vorteilhafte Weiterbildungen der Erfindung sind in den Unteransprüchen angegeben.

Die Erfindung beruht auf folgenden Überlegungen und Erkenntnissen. Bei terrestrischem Empfang sind die erste Mischstufe und die zweite Mischstufe für die zweifache Frequenzumsetzung bis auf die Zwischenfrequenzen von 38,9 MHz und 33,4 MHz wirksam. Bei Satellitenempfang ist nur die erste Mischstufe als Frequenzumsetzer wirksam, weil aus dem nur einmal in der Frequenz herabgesetzten ZF-Träger unmittelbar in einem PLL-Demodulator das Basisbandsignal des Satelliten-Antennensignal gewonnen wird. Bei der Erfindung wird nun bei Satellitenempfang die zweite Mischstufe als Bestandteil des PLL-Demodulators ausgenutzt, und zwar vorzugsweise als Phasenvergleichsstufe der PLL-Schaltung. Vorzugsweise ist dabei der Mischoszillator für die zweite Mischsstufe auf die erste Zwischenfrequenz abgestimmt. Durch diese Doppelausnutzung der zweiten Mischstufe, nämlich als zweite Mischstufe bei terrestrischem Empfang für die zweite Frequenzumsetzung und als Phasenvergleichsstufe des PLL-Demodulators bei Satellitenempfang ergibt sich ein geringer Schaltungsaufwand. Es wird dadurch ein Tuner geschaffen, der gleichermaßen das Antennensignal einer üblichen terrestrischen Antenne und das Antennensignal einer Satellitenantenne empfangen kann.

Vorzugsweise ist der Ausgang der zweiten Mischstufe über einen Umschalter bei terrestrischem Empfang an den Eingang einer zweiten ZF-Stufe und bei Satellitenempfang an den Eingang eines Tiefpasses angeschlossen, dessen Ausgang an den Steuereingang des Mischoszillators für die zweite Mischstufe und an eine das Basisbandsignal liefernde Klemme angeschlossen ist. Der Steuereingang des Mischoszillators ist dabei über einen Umschalter bei terrestrischem Empfang mit dem Ausgang einer von dem Mischoszillator und von einem I²C-Bus gesteuerten PLL-Schaltung und bei Satellitenempfang mit dem Ausgang des Tiefpasses der PLL-Schaltung verbunden. Der Tuner hat vorzugsweise einen ersten Eingang für ein in der Frequenz herabgesetztes Satelliten-Antennensignal und einen zweiten Eingang für ein terrestrisches Antennensignal. Beide Eingänge können auch zu einem Eingang zusammengefaßt sein. Diesem würde dann ein Antennensignal zugeführt, das bereits vorher, z.B. in der Nähe der Antennen, aus dem Antennensignal der terrestrischen Antenne und der Satellitenantenne zusammengesetzt ist. Der Tuner hat vorzugsweise einen ersten Ausgang für die zweite Zwischenfrequenz eines terrestrischen Antennensignals und einen zweiten Ausgang für das Basisbandsignal eines Satelliten-Antennensingals.

Die Erfindung wird im folgenden anhand der Zeichnung an einem Ausführungsbeispiel erläutert.

In der Figur liefert die Satelliten-Empfangsschüssel 1 ein Signal mit einer Frequenz in der Größenordnung von 11 GHz, das in dem LNC (low noise converter)-Umsetzer 2 in einen Frequenzbereich von 950 - 2050 MHz umgesetzt wird. Dieses Signal gelangt über den Antenneneingang 3 auf das auf diesen Frequenzbereich abgestimmte Filter 4. Dieses Signal gelangt über den von der AGC2 gesteuerten Verstärker 5 auf den ersten Eingang des Umschalters S2. Die terrestrische Antenne 6 liefert ein Antennensignal im Bereich von etwa 45 - 860 MHz, das auf den Antenneneingang 7 gelangt. Der Eingang 7 ist an den Bandpaß 8 mit einem Durchlaßbereich von 45 - 100 MHz (VHF), an den Bandpaß 9 mit einem Durchlaßbereich von 170 - 230 MHz (UHF), an den Bandpaß 10 mit einem Durchlaßbereich bei etwa 450 MHz und an den Bandpaß 11 mit einem Durchlaßbereich von 470 - 800 MHz angeschlossen. Mit dem Umschalter S1 können jeweils die Ausgangssignale der Bandfilter 8 - 11 ausgewählt und dem von der AGC1 gesteuerten Verstärker 12 zugeführt werden, dessen Ausgang an den zweiten Eingang des Umschalters S2 angeschlossen ist. Der jeweilige Träger am Ausgang des Schalters S2 wird in der ersten Mischstufe M1, die von dem Mischoszillator 13 gespeist wird, auf eine 1.ZF umgesetzt, die dem ZF-Filter 14 zugeführt wird. Der Mischoszillator 13 ist von der PLL-Schaltung 15 gesteuert, die entsprechend der jeweiligen Abstimmung von einem I²C-Bus gesteuert ist. Die 1.ZF gelangt von dem Bandfilter 14 über den Verstärker 16 auf die zweite Mischstufe M2, an die der Mischoszillator 17 angeschlossen ist, der bei terrestrischem Empfang ähnlich wie der Mischoszillator 13 von der PLL-Schaltung 18 gesteuert wird, die ihrerseits auch von dem I²C-Bus gesteuert wird. Der Ausgang der Mischstufe M2 ist über den Umschalter S3 einerseits mit dem Bandpaß 19 und den ZF-Verstärker 20 für die 2.ZF mit dem Ausgang 21 für die 2.ZF und andererseits über den Intergrator 22 mit dem Ausgang 23 verbunden. Der Steuereingang des Oszillators 17 ist über den Umschalter S4 wahlweise an den Ausgang der PLL-Schaltung 18 oder an den Ausgang des Integrators 22 anschaltbar.

Die Wirkungsweise dieses Tuners wird im folgenden nacheinander für den terrestrischen Empfang und den Satellitenempfang beschrieben. Die ausgezogene Stellung der Umschalter S1 - S4 gilt dabei für terrestrischen Empfang und die gestrichelte Stellung für Satellitenempfang.

### Terrestrischer Empfang über die Antenne 6

Es erfolgt eine zweifache Frequenzumsetzung mit den Mischstufen M1 und M2. Die Stufen M1, 13, 15 einerseits und die Stufen M2, 17, 18 andererseits arbeiten dann auf ähnliche Weise. Der Integrator 22 hat dabei durch die Stellung der Schalter S3 und S4 keine Wirkung. An dem Ausgang 21 erscheint die 2.ZF mit einem Bildträger bei 38,9 MHz und einem Tonträger bei 33,4 MHz, die der weiteren Signalverarbeitung zugeführt werden.

### Satellitenempfang über die Schüssel 7

Die Mischstufe M2, der Integrator 22 und der Oszillator 17 bilden jetzt eine vom Ausgangssignal des Verstärkers 16 synchronisierte PLL-Schaltung, die als FM-Demodulator arbeitet. Die Mischstufe M2 bildet dabei die Phasenvergleichsstufe, der Integrator 22 den Tiefpaß oder das Siebglied und der Oszillator 17 den spannungsgesteuerten Oszillator, im allgemeinen VCO genannt, der den FM-Demodulator bildenden PLL-Schaltung. Die Spannung Ur am Ausgang des Integrators 22 dient als Regelspannung für die Frequenz des Oszillators 17 in dem Sinne, daß dieser Oszillator 17 auf der Frequenz des frequenzmodulierten Trägers vom Ausgang des Verstärkers 16 schwingt. Da der Träger vom Verstärker 16 frequenzmoduliert ist, stellt Ur am Ausgang 23 gleichzeitig das Basisbandsignal dar, das aus dem Videosignal, dem Farbträger und mehreren Tonträgern besteht. Die PLL-Schaltung 18 ist dann wirkungslos, weil die Frequenz des Oszillators 17 nur durch Ur bestimmt ist. Bei dieser Betriebsart ist der Oszillator 17 auf die 1.ZF, also die Ruhefrequenz des Trägers am Ausgang des Verstärkers 16 abgestimmt. Die Mischstufe M2 wirkt also jetzt nicht als Mischstufe wie bei terrestrischem Empfang, sondern bildet in vorteilhafter Weise einen Bestandteil des durch die gestrichelte Linie 30 angedeuteten FM-PLL-Demodulators.

Die Schalter S1 - S4 sind vorzugsweise durch Schaltdioden gebildet. Grundsätzlich können sie auch als mechanische Schaltkontakte ausgebildet sein. Die gesamte dargestellte Schaltung außer der Filter selbst kann als integrierte Schaltung ausgebildet sein.

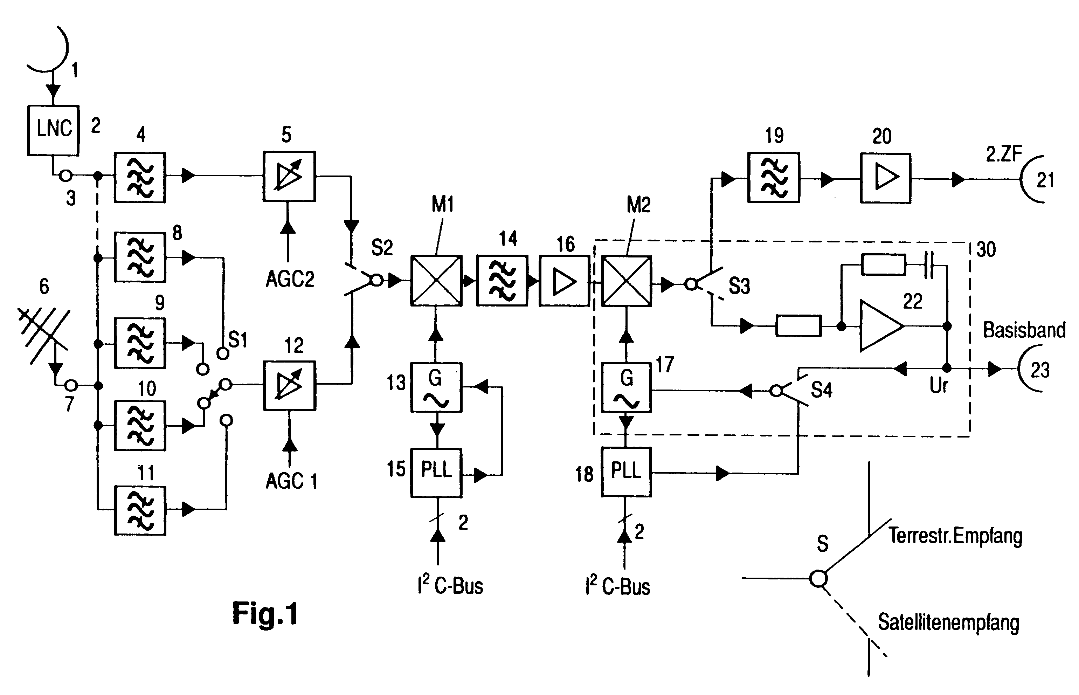

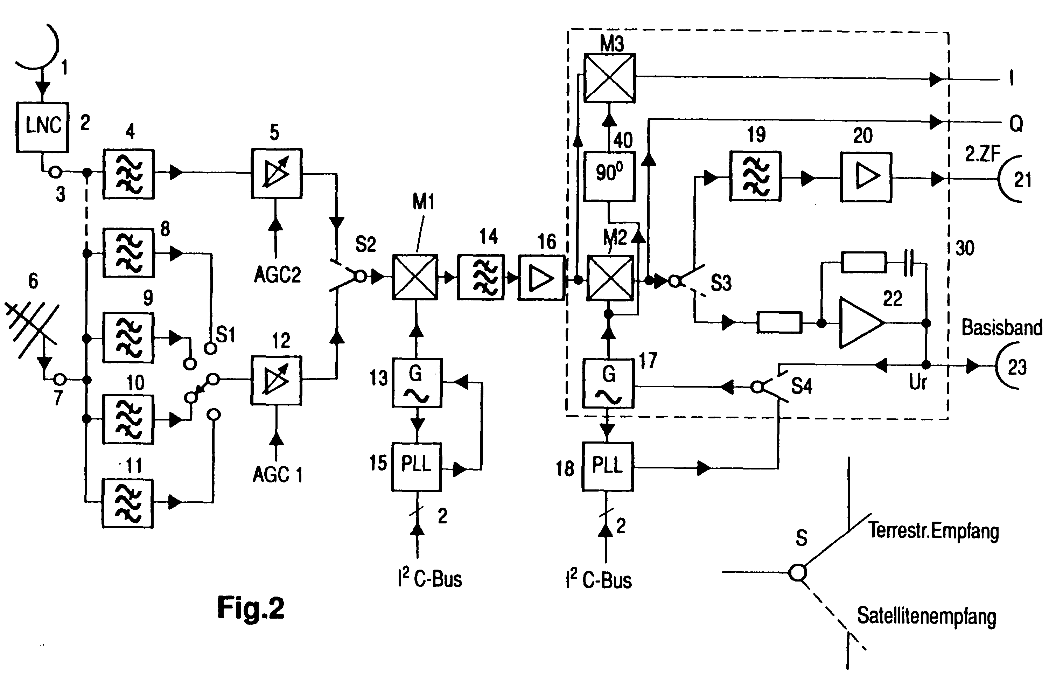

Fig.2 stellt eine Weiterbildung der Erfindung dar. Mit einer derart ausgebildeten Schaltung sind terrestrische als auch über Satelliten empfangene digitale Modulationssignale auswertbar. Zu diesem Zweck ist die Schaltung nach Fig. 1 durch einen 90° Phasendreher 40 und einen Mischer M3 ergänzt.

Vom Oszillator 17 wird ein Signal abgeleitet und über den 90° Phasendreher 40 dem Mischer M3 zugeführt. Das Oszillatorsignal wird zum einen dem Mischer M2 direkt und zum anderen dem Mischer M3 um 90° phasengedreht zugeführt. Am Ausgang der Mischer M3, M2 stehen dann die Komponenten I und Q an. Die Komponenten I und Q entsprechen bei der digitalen Modulation dem realen und imaginären Anteil eines Vektors, wobei I dem imaginären Anteil und Q dem realen Anteil entspricht. Das digitale Signal steht somit an den Ausgängen I und Q zu Verfügung.

## Patentansprüche

1. Fernsehtuner für terrestrischen Empfang und Satellitenempfang mit einer ersten Mischstufe (M1) zur Umsetzung auf eine erste Zwischenfrequenz und einer zweiten Mischstufe (M2) zur Umsetzung auf eine zweite Zwischenfrequenz, **dadurch gekennzeichnet**, daß die zweite Mischstufe (M2) bei terrestrischem Empfang als Mischer zum Umsetzen auf die zweite Zwischenfrequenz und bei Satellitenempfang als Phasenvergleichsstufe eines FM-PLL-Demodulators (30) für das Satellitensignal geschaltet ist.

2. Tuner nach Anspruch 2, **dadurch gekennzeichnet**, daß der Mischoszillator (17) für die zweite Mischstufe (M2) auf die erste Zwischenfrequenz abgestimmt ist.

3. Tuner nach Anspruch 1, **dadurch gekennzeichnet**, daß der Ausgang der zweiten Mischstufe (M2) über einen Umschalter (S3) bei terrestrischem Empfang an den Eingang einer zweiten ZF-Stufe (19, 20) und bei Satellitenempfang an den Eingang eines Integrators (22) angeschlossen ist, dessen Ausgang an den Steuereingang des Mischoszillators (17) für die zweite Mischstufe (M2) und an eine das Basisbandsignal liefernde Klemme (23) angeschlossen ist.

4. Tuner nach Anspruch 3, **dadurch gekennzeichnet**, daß der Steuereingang des Mischoszillators (17) über einen Umschalter (S4) bei terrestrischem Empfang mit dem Ausgang einer von dem Mischoszillator (17) und von einem I²C-Bus gesteuerten PLL-Schaltung (18) und bei Satellitenempfang mit dem Ausgang des Integrators (22) verbunden ist.

5. Tuner nach Anspruch 1, **dadurch gekennzeichnet**, daß die Schaltung als integrierte Schaltung ausgebildet ist.

6. Tuner nach Anspruch 1, **dadurch gekennzeichnet**, daß der Tuner einen ersten Eingang (3) für ein in der Frequenz herabgesetztes Satelliten-Antennensignal und einen zweiten Eingang (7) für ein terrestrisches Antennensignal aufweist.

7. Tuner nach Anspruch 1, **dadurch gekennzeichnet**, daß der Tuner einen ersten Ausgang (21) für die zweite Zwischenfrequenz eines terrestrischen Antennensignals und einen zweiten Ausgang (23) für das Basisbandsignal eines SatellitenAntennensignals aufweist.

8. Tuner nach Anspruch 1, **dadurch gekennzeichnet**, daß der Mischoszillator (17) für die zweite Mischstufe (M2) zusätzliich über einen 90°-Phasendreher (40) an den Eingang einer dritten Mischerstufe (M3) angeschlossen ist, an dessen anderen Eingang das Eingangssignal der zweiten Mischerstufe (M2) angelegt ist.

9. Tuner nach Anspruch 8, **dadurch gekennzeichnet**, daß am Ausgang der dritten Mischstufe (M3) ein imaginärer Anteil und am Ausgang der zweiten Mischstufe (M2) ein realer Anteil des Vektors eines digitalen Modulationssignals ansteht.

## Claims

1. Television tuner for terrestrial reception and satellite reception including a first mixer stage (M1) for converting to a first intermediate frequency and a second mixer stage (M2) for converting to a second intermediate frequency, characterised in that, in the case of terrestrial reception, the second mixer stage (M2) is connected up as a mixer for the purpose of converting to the second intermediate frequency and, in the case of satellite reception, it is connected up as the phase comparator stage of an FM PLL demodulator (30) for the satellite signal.

2. Tuner in accordance with Claim 2 [sic], characterised in that, the mixer oscillator (17) for the second mixer stage (M2) is tuned to the first intermediate frequency.

3. Tuner in accordance with claim 1, characterised in that, in the case of terrestrial reception, the output of the second mixer stage (M2) is connected via a switch (S3) to the input of a second IF stage (19, 20) and, in the case of satellite reception, it is connected to the input of an integrator (22) whose output is connected to the control input of the mixer oscillator (17) for the second mixer stage (M2) and to a terminal (23) which is supplying the base band signal.

4. Tuner in accordance with Claim 3, characterised in that, in the case of terrestrial reception, the control input of the mixer oscillator (17) is connected via a switch (S4) to the output of a PLL circuit (18) that is controlled by the mixer oscillator (17) and an I²C bus and, in the case of satellite reception, it is connected to the output of the integrator (22).

5. Tuner in accordance with Claim 1, characterised in that, the circuit is constructed as an integrated circuit.

6. Tuner in accordance with Claim 1, characterised in that, the tuner has a first input (3) for a satellite antenna signal that has been lowered in frequency and a second input (7) for a terrestrial antenna signal.

7. Tuner in accordance with Claim 1, characterised in that, the tuner has a first output (21) for the second intermediate frequency of a terrestrial antenna signal and a second output (23) for the base band signal of a satellite antenna signal.

8. Tuner in accordance with Claim 1, characterised in that, the mixer oscillator (17) for the second mixer stage (M2) is additionally connected via a 90° phase shifter (40) to the input of a third mixer stage (M3) to the other input of which the input signal from the second mixer stage (M2) is applied.

9. Tuner in accordance with Claim 8, characterised in that, an imaginary term of the vector of a digitally modulated signal is present at the output of the third mixer stage (M3) and a real term is present at the output of the second mixer stage (M2).

## Revendications

1. Syntoniseur télévisuel pour réception terrestre et par satellite avec un premier étage mélangeur (M1) pour conversion vers une première fréquence intermédiaire et un deuxième étage mélangeur (M2) pour conversion vers une deuxième fréquence intermédiaire, **caractérisé en ce que** le deuxième étage mélangeur (M2) fonctionne lors d'une réception terrestre comme mélangeur pour la conversion vers la deuxième fréquence intermédiaire et lors d'une réception par satellite comme étage de comparaison de phase d'un démodulateur FM à boucle à verrouillage de phase (30).

2. Syntoniseur selon la revendication 1, **caractérisé en ce que** l'oscillateur mélangeur (17) pour le deuxième étage mélangeur (M2) est accordé sur la première fréquence intermédiaire.

3. Syntoniseur selon la revendication 1, **caractérisé en ce que** la sortie du deuxième étage mélangeur (M2) est reliée via un commutateur (S3) lors d'une réception terrestre à l'entrée d'un deuxième étage à FI (19, 20) et lors d'une réception par satellite à l'entrée d'un intégrateur (22), dont la sortie est reliée à l'entrée de commande de l'oscillateur mélangeur (17) pour le deuxième étage mélangeur (M2) et à une borne (23) fournissant le signal en bande de base.

4. Syntoniseur selon la revendication 3, **caractérisé en ce que** l'entrée de commande de l'oscillateur mélangeur (17) est reliée via un commutateur (S4) lors d'une réception terrestre avec la sortie d'un circuit à boucle à verrouillage de phase commandé par l'oscillateur mélangeur (17) et par un bus I²C et lors d'une réception par satellite avec la sortie de l'intégrateur (22).

5. Syntoniseur selon la revendication 1, **caractérisé en ce que** le circuit est réalisé sous la forme d'un circuit intégré.

6. Syntoniseur selon la revendication 1, **caractérisé en ce que** le syntoniseur présente une première entrée (3) pour un signal d'antenne de satellite transposé à une fréquence inférieure et une deuxième entrée (7) pour un signal d'antenne terrestre.

7. Syntoniseur selon la revendication 1, **caractérisé en ce que** le syntoniseur présente une première sortie (21) pour la deuxième fréquence intermédiaire d'un signal d'antenne terrestre et une deuxième sortie (23) pour le signal en bande de base d'un signal d'antenne de satellite.

8. Syntoniseur selon la revendication 1, **caractérisé en ce que** l'oscillateur mélangeur (17) pour le deuxième étage mélangeur (M2) est relié en plus via un déphaseur rotatif de 90° (40) à l'entrée d'un troisième étage mélangeur (M3), à l'autre entrée duquel le signal d'entrée du deuxième étage mélangeur (M2) est appliqué. ⁽¹⁾

9. Syntoniseur selon la revendication 8, **caractérisé en ce qu'**à la sortie du troisième étage mélangeur (M3), apparaît une partie imaginaire et à la sortie du deuxième étage mélangeur (M2) une partie réelle du vecteur d'un signal modulé numérique.
